# EUROPEAN PATENT SPECIFICATION

(11) **EP 2 641 459 B1**
(45) Date of publication and mention of the grant of the patent: **15.11.2017**
(21) Application number: 12705998.8
(22) Date of filing: 13.02.2012
(51) Int. Cl.: H05K 9/00

(54) **AN ELECTRONICS DEVICE, AND A METHOD FOR MAKING THE SAME**
ELEKTROOPTISCHE VORRICHTUNG UND HERSTELLUNGSVERFAHREN DAFÜR
DISPOSITIF ÉLECTRONIQUE ET SON PROCÉDÉ DE FABRICATION

(43) Date of publication of application: 25.09.2013
(73) Proprietor: Huawei Technologies Co., Ltd., Longgang District Shenzhen, Guangdong 518129 (CN)
(72) Inventor: HEDEROTH, Johnny, 16440 Kista (SE)
(74) Representative: Pfenning, Meinig & Partner mbB
(86) International application number: PCT/EP2012/052385
(87) International publication number: WO 2013/120507

(56) References cited:
- US-A- 5 717 577

## Description

### Field of the invention

The present invention relates to an electronics device with an improved mounting of the shield for electromagnetic shielding of electronics components mounted to a Printed Circuit Board, and to a method of making the same.

### Background of the invention

The present invention relates generally to an electronics device having a first housing part connected with a second housing part. The second housing part includes a Printed Circuit Board (PCB) with electronics components, an electromagnetic shielding cover being mounted for electromagnetic shielding (ES) of the electronics components, the cover including a bottom or base wall spaced apart from the PCB and projecting walls contacting the PCB, the projecting walls being arranged to surround one or more of the electronics components.

In such known electronics devices the electromagnetic shielding cover is normally secured by means of a large number of screws extending through holes in the PCB. The relatively large number of screw holes in the PCB increases the overall dimensions of the PCB for there to be sufficient area for PCB conductor tracks and electronics components required for the proper functioning of the device. This again requires the device to have large external dimensions for fitting the PCB inside.

US 5,717,577 discloses an electronics device with a semi-lossy gasket between a printed circuit board ground pad ring and a metal shield can for shielding electronic components and circuitry which generate electromagnetic radiation. In one of the embodiments, a stand-off is situated between a housing and the shield can to apply sufficient pressure between the can and the housing.

### Summary of the invention

An object of the invention is to propose a simplified assembly of the device which inter alia will also provide to an increased PCB area available for conductor tracks, without increasing the overall dimensions of the device. According to one aspect of the invention the device includes compressible members arranged between the cover and the first housing part, an engagement structure opposite the cover engaging and compressing the compressible member(s). A bottom wall of the electromagnetic shielding cover and the engagement structure include at least one projection mating with a recess for positioning one of said compressible member(s). In this manner the screws required for fixing the cover is reduced substantially, or eliminated.

According to another aspect of the invention the projecting walls include a compressible gasket of an electrically conductive material, the gasket contacting the PCB and being compressed.

According to yet another aspect the compressible members are conical washers, or each defined by a stack of such washers, and the bottom wall and the engagement structure may include at least one projection mating with a recess to position the washers.

According to a further aspect of the invention also the first housing part includes a Printed Circuit Board (PCB) with electronics components and an electromagnetic shielding cover for electromagnetic shielding of electronics components of the first housing part. This cover includes a bottom wall which defines the engagement structure that engages and compresses the compressible member (s) upon assembly of the device by the two housing parts being connected together.

The invention also relates to a method of making the aforementioned wherein the Printed Circuit Board (PCB) with electronics components and the electromagnetic shielding cover are first mounted to the second housing with the projecting walls surrounding one or more of the electronics components, and wherein the first housing part is then connected to the second housing part while compressing and maintaining a compression of the compressible member(s) by the engagement structure opposite the cover engaging and compressing the compressible member (s) .

Further aspect of the invention be appear from the below detailed description.

### Brief description of the drawings and detailed description of the invention

The invention will now be described with reference to the drawings that show a preferred embodiment.
Fig. 1a is a perspective exploded view of a prior art electronics device,
Fig. 1b is a perspective bottom view of an electromagnetic shielding (ES) cover,
Fig. 1c is a cross-sectional view of a portion of the prior art device of fig. 1a, when assembled,
Fig. 1d is a view taken along line 1d-1d in fig. 1c,
Fig. 2a is a perspective exploded view of a modification in accordance with the invention of the prior art electronics device of fig. 1a-d,
Fig. 2b is a perspective view of the components of fig. 2a in an assembled state,
Fig. 2c is a cross-sectional side view of a portion of the assembled device of fig. 2b,
Fig. 2d shows and example of a compressible member in the form of a conical washer, or a stack of conical washers, respectively,
Fig. 2e is a view similar to fig. 2c, immediately before the two housing parts are assembled, and
Fig. 2f is a view taken along line 2f-2f in fig. 2c.

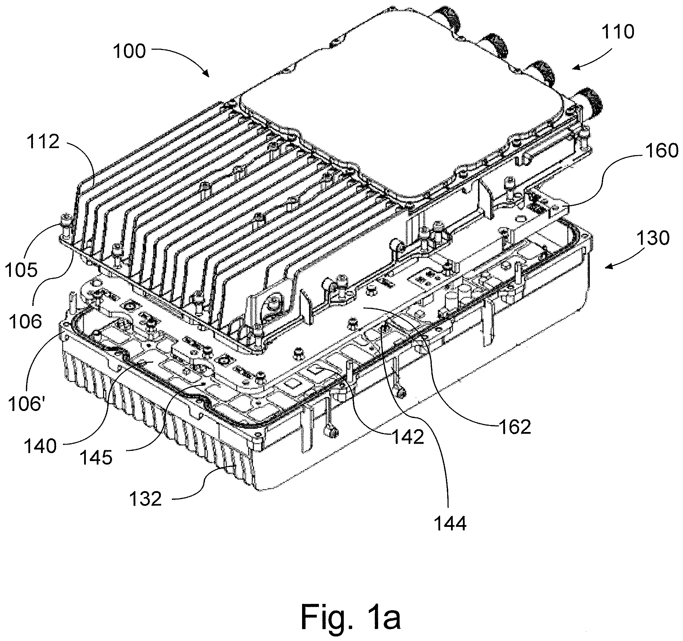

Fig. 1a is a perspective exploded view of a prior art electronics device 100 which may, by way of example, be a radio remote unit including a cavity microwave filter arranged in an upper or first housing part 110 having a series of cooling ribs 112. On assembling the device 100 the first housing part 110 is connected to a second or lower housing part 130 by means of screws 105, each passing through a respective peripheral flange 106, 106' along the periphery of the first housing part 110 and of the second housing part 130. The second housing part 130 may also have a series of cooling ribs, as shown by reference numeral 132.

The first housing part 110 and the second housing part 130 each include a printed circuit board (PCB) 140, each PCB 140 having an Electromagnetic Shielding (ES) cover 160 (sometimes also referred to as an Electro Magnetic Compatibility (EMC) cover) for electromagnetic shielding of electronics components 142 mounted to a surface of the PCB. Fig. 1a only shows the PCB 140 and the ES cover 160 of the second or lower housing part 130.

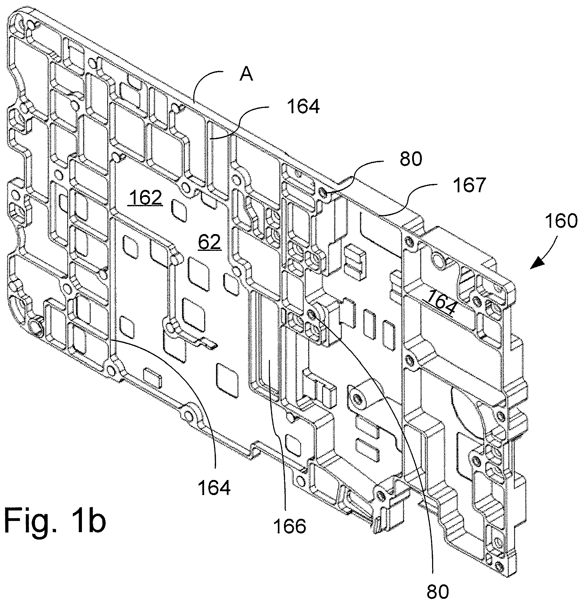

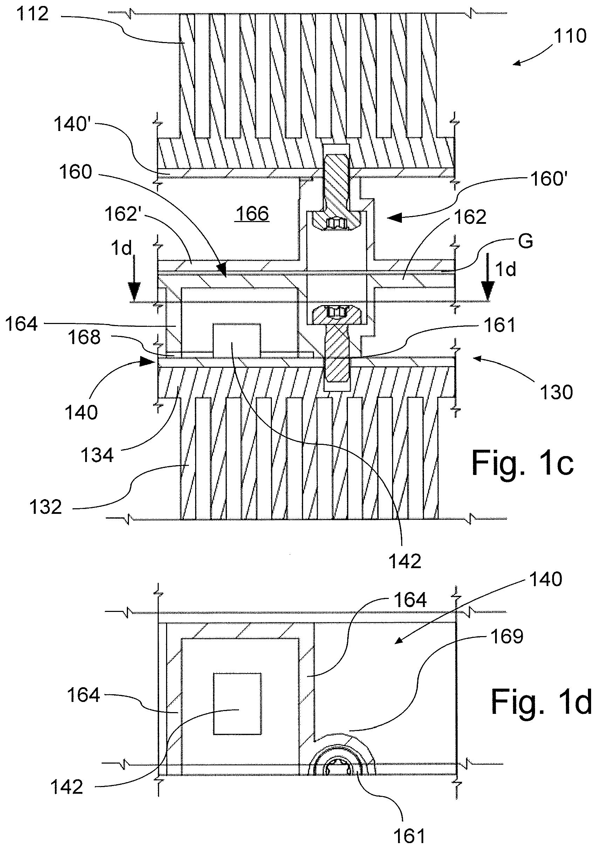

Fig. 1b is a perspective bottom view of an ES cover 160 as illustrated in fig. 1a and having a peripheral edge A; the ES cover 160 is typically of die-cast aluminium or metallized plastic, and has a bottom wall 162 with a plurality of perpendicularly extending depending walls 164 on one face. When placed on the PCB 140 the bottom wall 162 and the walls 164 define compartments or enclosures 166, each compartment 166 receiving a corresponding electronics component 142 mounted to the upper surface of the PCB 130 shown in fig. 1a, to provide electromagnetic shielding of the electronics component 142 in relation to neighbouring electronics components mounted to the upper surface of the PCB 140. The end surface 167 of all the walls 164 is preferably defined by a compressible electrically conductive gasket (not shown) that is held against the PCB 130 to ensure proper electrical contact with the PCB. The walls 164 including the compressible gasket are preferably arranged so as to seal off each compartment 166 along its entire periphery, as shown in fig. 1c; the walls 164 and the bottom wall 162 may have through-going apertures. The compressible gasket may by way of example be formed of a bead of conductive silicone, such as in the form of an oven cured thixotropic liquid dispensed to define the end surfaces 167 with a bead height normally between 0.5 mm and 2.5 mm.

Fig. 1c is a cross-sectional view of a portion of the prior art device 100 of fig. 1a, when assembled. The PCB 140 is secured to a bottom wall 134 of the second housing part 130 by means of PCB-screws 144 (of which one is shown in fig. 1a) that extend through corresponding holes formed in the PCB 140 and into the bottom wall 134. Further holes 145 are provided in the PCB 140, for receiving mounting screws 161 that extend from corresponding holes in the ES cover 160 and into the bottom wall 134, to secure the ES cover 160 to the second housing part 130. The screws 161 are tightened to such an extent that that aforementioned compressible gasket, which is shown in fig. 1c by numeral 168, is compressed to ensure good electrical contact, preferably with no air gaps between the walls 164 and the PCB 140, i.e. to air-tightly enclose an electronics component 142 within the compartment 166. For this purpose a relatively large number of mounting screws 161, distributed across the ES cover 160, is required.

Shown in fig. 1c is also a further PCB 140' and ES cover 160' included in the first or upper housing part 110; a gap G between the faces of the bottom wall 162, 162' of the two ES covers 160, 160' is provided to allow for tolerances.

Fig. 1d is a view taken along line 1d-1d in fig. 1c, illustrating the electronics component 142 on the PCB 140 and a portion of the wall 164 that completely surrounds the electronics component 142. It will be understood that the large number of mounting screws 161 distributed across the ES cover 130 and required to properly compress the gasket 168 in the area of the compartments 166 require there to be a large number of corresponding through-going holes in the PCB 140. The relatively large number of holes in the PCB 140 reduces the area available for PCB conductor tracks and electronics components 142 and thus requires the device 100 to have large external dimensions for fitting the PCB inside the housing parts 110, 130.

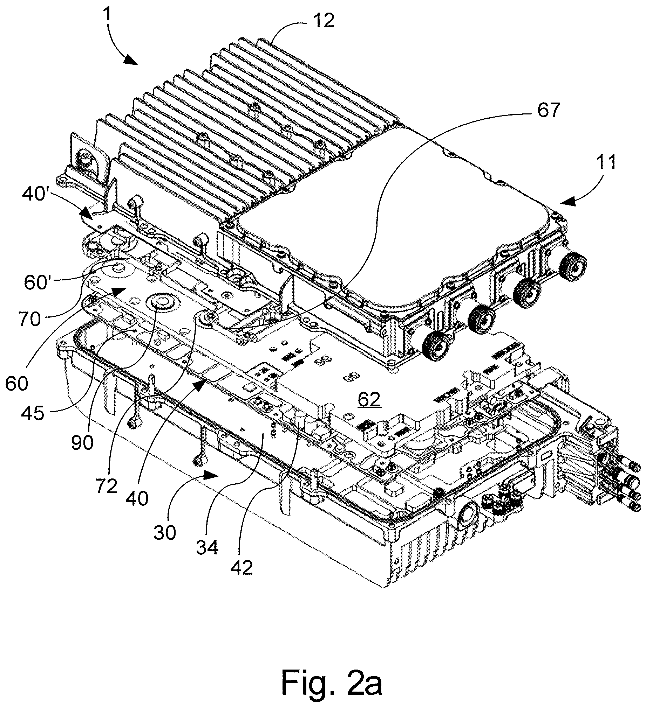

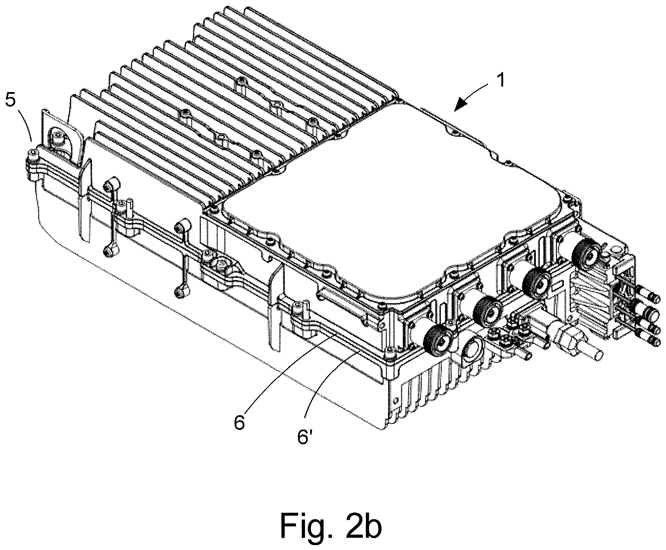

Fig. 2a is a perspective exploded view of the prior art electronics device of fig. 1a-d, modified in accordance with present invention, to define an embodiment of a novel electronics device 1 having an upper or first housing part 11 which may have a series of cooling ribs 12, and a second or lower housing part 30. The two housing parts 11, 30 are assembled, as shown in fig. 2b, by means of screws 5, each passing through a peripheral flange 6, 6' of the first housing part 11 and of the second housing part 30. For purpose of illustration the device 1 of fig. 2a is for the same use as that of fig. 1a, and has the same general structure; structural differences are outlined below. It will be understood that the novel technical features specifically discussed below may be used in connection with devices having a use different from the device 100 of fig. 1a.

In the shown embodiment the first housing part 11 and the second housing part 30 each have a bottom wall 34 and each include a printed circuit board (PCB) 40, 40', an electromagnetic shielding (ES) cover 60, 60' being provided for each PCB 40, 40' for electromagnetic shielding of the electronics components 42 mounted to the surface of the PCB 40, 40'.

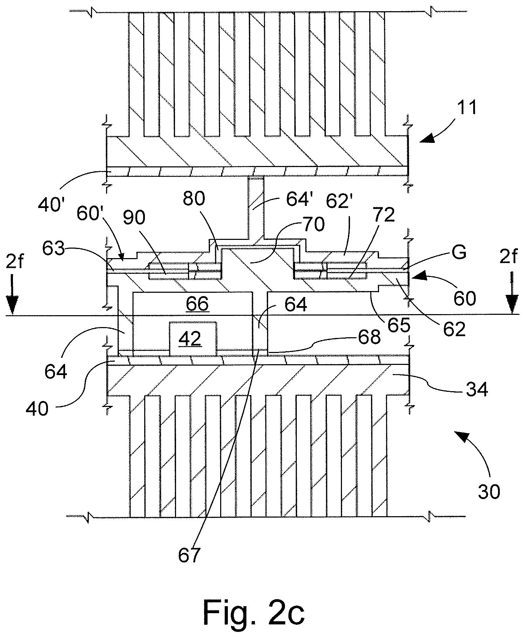

The invention involves the use of a modification of the ES cover illustrated in fig. 1a, still with a bottom wall referenced in the following by numeral 62 having on one face 65 a plurality of perpendicularly projecting depending walls, referenced here by numeral 64, surrounding one or more electronics components 42 to define compartments or enclosures 66, the bottom wall 62 being spaced apart from the PCB 40 such that each compartment 66 receives the one more corresponding electronics component 42 mounted to the surface of an adjoining PCB 30, to provide electromagnetic shielding in relation to neighbouring electronics components 42 mounted to the PCB 30 outside the compartment 66. The walls 64 and the bottom wall 62 may in some cases have through-going apertures, such as for ventilation. Again, the walls 64 preferably include a compressible conductive gasket 68 as described above with reference to fig. 1a and 1c that defines the end surface 67 of the walls 64 and ensures required conductance, and which may seal off each compartment 66 along the entire periphery thereof, as shown in fig. 2c.

Fig. 2c is a cross-sectional side view of a portion of the assembled device 1 of fig. 2b. The PCB 40 is secured to the bottom wall 34 of the second or lower housing part 30 by means of PCB-screws (not shown) that extend through corresponding holes formed in the PCB 40 and into the bottom wall 34 of the second housing part 30. The other PCB 40' is secured to the bottom wall 62' of the first housing part 11, and the corresponding ES cover 60' has a bottom wall 62' that faces the upper face 63 of the bottom wall 62 of the other ES cover 60.

To compress the aforementioned gasket 68 in order to ensure good contact, preferably without any air gaps, between the walls 64 and the PCB 40 the invention involves the use of compressible members 90 distributed on the upper face 63 of the bottom wall 62 in the gap G or interface between the two housing parts 11, 30, as shown in fig. 2a and 2c, and discussed further below. The compressible members 90 are arranged to be compressed by an engagement structure when pressing the two housing parts 11, 30 together, such as when the screws 5 along the peripheral flanges 6, 6' are tightened, thereby providing a force compressing the compressible gasket 68.

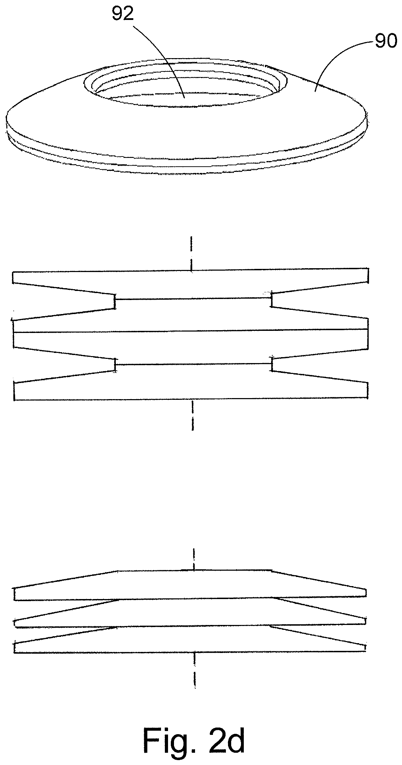

By way of example the compressible members may be an elastically compressible disc-shaped steel Belleville/conical washer 90, or a stack of such disc-shaped washers, as shown in fig. 2d, applying a desired force against the ES cover 30 upon a given compression. Other compressible members, such as elastomeric material blocks and not necessarily formed as washers, may be also be used.

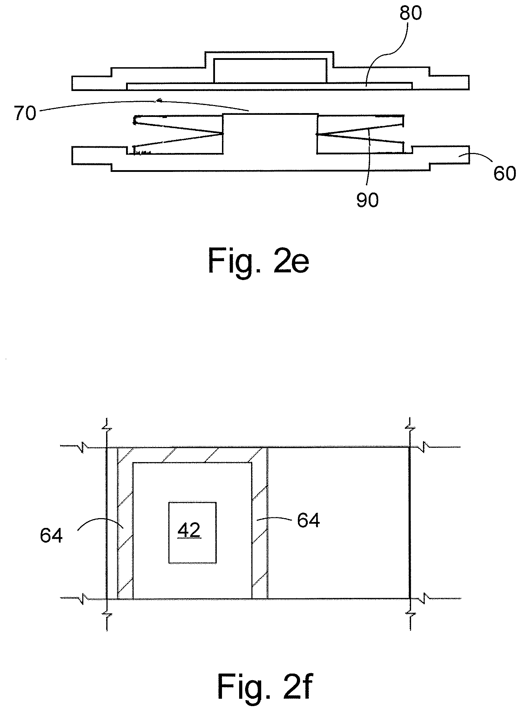

Fig. 2e is a view similar to fig. 2c but illustrating only portions of the structure shown in fig. 2c, immediately before the two housing parts 11, 30 are assembled and with the compressible members 90 in the yet uncompressed state. As shown also in fig. 2a and 2c the bottom wall 62 of one of the ES covers 60 is on the side facing away from the walls 64 provided with a plurality of projections formed as knobs 70 for the purpose of locating the conical washers 90 by extending through the central opening 92 thereof. A recess 72 in the upper face 63 surrounds the knobs 70 to receive the washer 90. For properly locating the first and second housing 11, 30 in respect to each other the knobs 70 may be sized to be received in recesses 80 formed in the opposed ES cover 60, as shown in figs. 2c and 2e.

The ES cover 60' of the first housing part 11 includes a compressible member 90 engagement structure in that portion of the lower face of the bottom wall 62' surrounding the recesses 80 and facing the conical washers 90 is configured to bear against the conical washer(s) 90 upon the first housing part 11 being connected to the second housing part 30, whereby the compressible members, here the conical washers 90, are compressed or flattened to the state shown in fig. 2c.

Fig. 2f is a view taken along line 2f-2f in fig. 2c, illustrating the electronics component 42 on the PCB 40 and a portion of the wall 64 that completely surrounds the electronics component 142.

It will be understood that where only one of the housing parts, such as the lower housing part 30, have a PCB 40 with a corresponding ES cover 60 then the opposite housing part 11' may as such have depending wall portions or projections 64' defining the aforementioned engagement structure with areas 62' acting against the compressible members 90, in the manner discussed above, to press the wall 64 towards the PCB 40.

Through the invention only a few holes (45, see fig. 2a) compared to the prior art of fig. 1a need be provided in the PCB 40, for receiving a few mounting screws that extend through corresponding holes in the ES cover 60 and into the bottom wall 34; these few mounting screws are used mainly for maintaining the position of the ES cover 60 in relation to the second housing part 30, before the two housing parts 11, 30 are connected to each other by tightening the screws 5 along the peripheral flanges 6, 6'. Compared to the prior art of fig. 1c fewer such mounting screws are used since compression of the gasket is by tightening the screws 5, requiring fewer through-going holes 45 to be formed in the PCB 40, thereby increasing the PCB area available for conductor tracks and electronics components. Where the holes 145 are surrounded by upstanding towers 169 as shown in fig.1d the increased available PCB area may be up to 1cm² per hole 145, leading to an even higher increase in the area available for conductors on the PCB 40.

## Claims

1. An electronics device (1) having a first housing part (11) connected with a second housing part (30), said second housing part (30) including a Printed Circuit Board (PCB) (40) with electronics components (42), an electromagnetic shielding cover (60) being mounted for electromagnetic shielding of said electronics components (42), said cover (60) including a bottom wall (62) spaced apart from said PCB (40) and projecting walls (64) contacting said PCB (40), said projecting walls (64) being arranged to surround one or more of said electronics components (42), said device (1) including compressible member(s) (90) arranged between said cover (60) and said first housing part (11), an engagement structure (62', 64') opposite said cover (60) engaging and compressing said compressible member(s) (90) and said bottom wall (62) and said engagement structure (62', 64') including at least one projection (70) mating with a recess (80) with said mating projection (70) or said recess (80) positioning one of said compressible members (90).

2. The device of claim 1, said projecting walls (64, 64') including a compressible gasket (68) of an electrically conductive material, said gasket being compressed and contacting said PCB (40, 40').

3. The device of claims 1 or 2, said cover (60) having a peripheral edge (A), said compressible member(s) (90) being arranged in central areas of said cover (60), distant from said peripheral edge (A).

4. The device according to any of the preceding claims, said compressible member(s) (90) being elastically compressible.

5. The device according to any of the preceding claims, said compressible members (90) being Belleville/conical washers (90).

6. The device according to the preceding claim, said compressible member (90) being a stack of said washers (90).

7. The device according to any of the preceding claims, said connection between said first housing part (11) and said second housing part (30) maintaining said compression of said compressible member(s) (90).

8. The device according to any of the preceding claims, said first housing part (11) being connected with said second housing part (30) along a periphery (6, 6') of said device (1).

9. The device according to any of the preceding claims, said engagement structure comprising a projecting wall (64') structure of said first housing part (11).

10. The device according to any of the preceding claims, said first housing part including a further Printed Circuit Board (PCB) (40') with electronics components (42), a further electromagnetic shielding cover (60') being provided for electromagnetic shielding of said electronics components (42) of said further PCB, said further cover (60') including a bottom wall (62') spaced apart from said further PCB (40') and projecting walls (64') contacting said further PCB (40') and being arranged to surround one or more of said electronics components (42) of said further PCB (40'), said further cover (60') defining said engagement structure engaging and compressing said compressible member(s) (90).

11. The device according to any of the preceding claims, said projecting walls (64) and said bottom wall (62) having through-going apertures.

12. A method of making the device (1) according to any of the preceding claims wherein said Printed Circuit Board (PCB) (40) with electronics components (42) and said electromagnetic shielding cover (60) are first mounted to said second housing (30) with said projecting walls (64) surrounding one or more of said electronics components (42), and wherein said first housing part (11) is then connected to said second housing part (30) while compressing and maintaining a compression of said compressible member(s) (90) by said engagement structure (62', 64') opposite said cover (60) engaging and compressing said compressible member(s) (90).

13. The method of claim 12, wherein said first housing part (11) is connected to said second housing part (30) along a periphery of said device (1).

## Patentansprüche

1. Elektronikvorrichtung (1), die einen ersten Gehäuseteil (11), der mit einem zweiten Gehäuseteil (30) verbunden ist, aufweist, wobei der zweite Gehäuseteil (30) eine Leiterplatte (PCB) (40) mit Elektronikkomponenten (42), eine elektromagnetisch abschirmende Abdeckung (60), die zum elektromagnetischen Abschirmen der Elektronikkomponenten (42) montiert ist, enthält, wobei die Abdeckung (60) eine Bodenwand (62), die von der PCB (40) beabstandet ist, und vorstehende Wände (64), die mit der PCB (40) in Kontakt sind, enthält, wobei die vorstehenden Wände (64) so angeordnet sind, dass sie eine oder mehrere der Elektronikkomponenten (42) umgeben, wobei die Vorrichtung (1) ein oder mehrere komprimierbare Elemente (90), die zwischen der Abdeckung (60) und dem ersten Gehäuseteil (11) angeordnet sind, eine Eingriffsstruktur (62', 64') gegenüber der Abdeckung (60), die mit dem einen oder den mehreren komprimierbaren Elementen (90) und der Bodenwand (62) in Eingriff ist und sie komprimiert, enthält, und wobei die Eingriffsstruktur (62', 64') wenigstens einen Vorsprung (70) enthält, der mit einer Aussparung (80) zusammenpasst, wobei der zusammenpassende Vorsprung (70) oder die Aussparung (80) eines der komprimierbaren Elemente (90) positioniert.

2. Vorrichtung nach Anspruch 1, wobei die vorstehenden Wände (64, 64') eine komprimierbare Dichtung (68) aus einem elektrisch leitfähigen Material enthalten, wobei die Dichtung komprimiert und mit der PCB (40, 40') in Kontakt ist.

3. Vorrichtung nach Anspruch 1 oder 2, wobei die Abdeckung (60) einen Umfangsrand (A) aufweist, wobei das eine oder die mehreren komprimierbaren Elemente (90) in mittleren Bereichen der Abdeckung (60) entfernt von dem Umfangsrand (A) angeordnet sind.

4. Vorrichtung nach einem der vorhergehenden Ansprüche, wobei das eine oder die mehreren komprimierbaren Elemente (90) elastisch komprimierbar sind.

5. Vorrichtung nach einem der vorhergehenden Ansprüche, wobei die komprimierbaren Elemente (90) Belleville-/konische Dichtungsringe (90) sind.

6. Vorrichtung dem vorhergehenden Anspruch, wobei das komprimierbare Element (90) ein Stapel aus den Dichtungsringen (90) ist.

7. Vorrichtung nach einem der vorhergehenden Ansprüche, wobei die Verbindung zwischen dem ersten Gehäuseteil (11) und dem zweiten Gehäuseteil (30) die Kompression des einen oder der mehreren komprimierbaren Elemente (90) aufrechterhält.

8. Vorrichtung nach einem der vorhergehenden Ansprüche, wobei der erste Gehäuseteil (11) mit dem zweiten Gehäuseteil (30) entlang einem Umfang (6, 6') der Vorrichtung (1) verbunden ist.

9. Vorrichtung nach einem der vorhergehenden Ansprüche, wobei die Eingriffsstruktur eine vorstehende-Wand(64')-Struktur des ersten Gehäuseteils (11) umfasst.

10. Vorrichtung nach einem der vorhergehenden Ansprüche, wobei der erste Gehäuseteil eine weitere Leiterplatte (PCB) (40') mit Elektronikkomponenten (42), eine weitere elektromagnetisch abschirmende Abdeckung (60'), die zum elektromagnetischen Abschirmen der Elektronikkomponenten (42) der weiteren PCB bereitgestellt ist, enthält, wobei die weitere Abdeckung (60') eine Bodenwand (62'), die von der weiteren PCB (40') beabstandet ist, und vorstehende Wände (64'), die mit der weiteren PCB (40') in Kontakt sind und angeordnet sind, um eine oder mehrere der Elektronikkomponenten (42) der weiteren PCB (40') zu umgeben, enthält, wobei die weitere Abdeckung (60') die Eingriffsstruktur definiert, die mit dem einen oder den mehreren komprimierbaren Elementen (90) in Eingriff ist und sie komprimiert.

11. Vorrichtung nach einem der vorhergehenden Ansprüche, wobei die vorstehenden Wände (64) und die Bodenwand (62) durchgehende Öffnungen aufweisen.

12. Verfahren zum Herstellen der Vorrichtung (1) nach einem der vorhergehenden Ansprüche, wobei die Leiterplatte (PCB) (40) mit Elektronikkomponenten (42) und die elektromagnetisch abschirmende Abdeckung (60) zuerst an das zweite Gehäuse (30) montiert werden, wobei die vorstehenden Wände (64) eine oder mehrere der Elektronikkomponenten (42) umgeben, und wobei der erste Gehäuseteil (11) dann mit dem zweiten Gehäuseteil (30) verbunden wird, während das eine oder die mehreren komprimierbaren Elemente (90) durch die Eingriffsstruktur (62', 64') komprimiert sind und die Kompression aufrecht erhalten wird, gegenüber der Abdeckung (60), die mit dem einen oder den mehreren komprimierbaren Elementen (90) in Eingriff ist und sie komprimiert.

13. Verfahren nach Anspruch 12, wobei der erste Gehäuseteil (11) mit dem zweiten Gehäuseteil (30) entlang einem Umfang der Vorrichtung (1) verbunden ist.

## Revendications

1. Dispositif électronique (1) possédant une première partie de logement (11) raccordée à une deuxième partie de logement (30), ladite deuxième partie de logement (30) comprenant une carte à circuit imprimé (PCB) (40) munie de composants électroniques (42), un capot de blindage électromagnétique (60) étant monté pour assurer le blindage électromagnétique desdits composants électroniques (42), ledit capot (60) comprenant une paroi inférieure (62) espacée de ladite PCB (40) et des parois en saillie (64) entrant en contact avec ladite PCB (40), lesdites parois en saillie (64) étant agencées de façon à entourer un ou plusieurs desdits composants électroniques (42), ledit dispositif (1) comprenant un ou plusieurs éléments compressibles (90) agencés entre ledit capot (60) et ladite première partie de logement (11), une structure d'engagement (62', 64') opposée audit capot (60) venant en prise avec et compressant lesdits un ou plusieurs éléments compressibles (90) et ladite paroi inférieure (62), et ladite structure d'engagement (62', 64') contenant au moins une saillie (70) en correspondance avec un renfoncement (80), ladite saillie (70) en correspondance ou ledit renfoncement (80) servant à positionner un desdits éléments compressibles (90).

2. Dispositif selon la revendication 1, lesdites parois en saillie (64, 64') comprenant un joint compressible (68) d'un matériau électriquement conducteur, ledit joint étant compressé et entrant en contact avec ladite PCB (40, 40').

3. Dispositif selon la revendication 1 ou 2, ledit capot (60) ayant un bord périphérique (A), lesdits un ou plusieurs éléments compressibles (90) étant agencés dans des zones centrales dudit capot (60), distantes dudit bord périphérique (A).

4. Dispositif selon l'une quelconque des revendications précédentes, lesdits un ou plusieurs éléments compressibles (90) étant compressibles de manière élastique.

5. Dispositif selon l'une quelconque des revendications précédentes, lesdits éléments compressibles (90) étant des entretoises Belleville/coniques (90).

6. Dispositif selon l'une quelconque des revendications précédentes, dans lequel ledit élément compressible (90) étant un empilement desdites entretoises (90).

7. Dispositif selon l'une quelconque des revendications précédentes, ledit raccordement entre ladite première partie de logement (11) et ladite deuxième partie de logement (30) maintenant ladite compression desdits un ou plusieurs éléments compressibles (90).

8. Dispositif selon l'une quelconque des revendications précédentes, ladite première partie de logement (11) étant raccordée à ladite deuxième partie de logement (30) le long d'une périphérie (6, 6') dudit dispositif (1).

9. Dispositif selon l'une quelconque des revendications précédentes, ladite structure d'engagement comprenant une structure de paroi en saillie (64') de ladite première partie de logement (11).

10. Dispositif selon l'une quelconque des revendications précédentes, ladite première partie de logement comprenant une autre carte à circuit imprimé (PCB) (40') munie de composants électroniques (42), un autre capot de blindage électromagnétique (60') étant monté pour assurer le blindage électromagnétique desdits composants électroniques (42) de ladite autre PCB, ledit autre capot (60') comprenant une paroi inférieure (62') espacée de ladite autre PCB (40') et des parois en saillie (64') entrant en contact avec ladite autre PCB (40) et étant agencées de façon à entourer un ou plusieurs desdits composants électroniques (42) de ladite autre PCB (40'), ledit autre capot (60') définissant ladite structure d'engagement venant en prise avec et compressant lesdits un ou plusieurs éléments compressibles (90).

11. Dispositif selon l'une quelconque des revendications précédentes, lesdites parois en saillie (64) et ladite paroi inférieure (62) ayant des ouvertures de traversée.

12. Procédé de fabrication du dispositif (1) selon l'une quelconque des revendications précédentes, dans lequel ladite carte à circuit imprimé (PCB) (40) munie de composants électroniques (42) et ledit capot de blindage électromagnétique (60) sont d'abord montés sur ledit deuxième logement (30) avec lesdites parois en saillie (64) qui entourent un ou plusieurs desdits composants électroniques (42), et dans lequel ladite première partie de logement (11) est ensuite raccordée à ladite deuxième partie de logement (30) tout en compressant et maintenant une compression desdits un ou plusieurs éléments compressibles (90) au moyen de ladite structure d'engagement (62', 64') opposée audit capot (60) venant en prise avec et compressant lesdits un ou plusieurs éléments compressibles (90).

13. Procédé selon la revendication 12, dans lequel ladite première partie de logement (11) est raccordée à ladite deuxième partie de logement (30) le long d'une périphérie dudit dispositif (1).
